# EUROPEAN PATENT APPLICATION

(11) **EP 4 715 764 A1**
(43) Date of publication of application: **25.03.2026**
(21) Application number: 24832217.4
(22) Date of filing: 30.04.2024
(51) Int. Cl.: G06V 40/13, H01L 23/498, H01L 23/538, H01L 23/31, H01L 21/78, H01L 21/56

(54) **ELECTRONIC DEVICE INCLUDING FINGERPRINT SENSOR**

(30) Priority: 30.06.2023 KR 20230085376; 19.07.2023 KR 20230094205
(71) Applicant: Samsung Electronics Co., Ltd., Suwon-si, Gyeonggi-do 16677 (KR)
(72) Inventor: HWANG, Seungho, Suwon-si, Gyeonggi-do 16677 (KR); HEO, Jihun, Suwon-si, Gyeonggi-do 16677 (KR); KIM, Hyunwoo, Suwon-si, Gyeonggi-do 16677 (KR); PARK, Jihoon, Suwon-si, Gyeonggi-do 16677 (KR)
(74) Representative: Gulde & Partner
(86) International application number: PCT/KR2024/005880
(87) International publication number: WO 2025/005432

(57) **Abstract**

This electronic device may include a substrate, a fingerprint sensor circuit, an insulating member, a plurality of pads, and a connection member. The substrate may include a first surface including a first area and a second area spaced apart from the first area, a second surface opposite to the first surface, and a third surface extending from an edge of the first surface to an edge of the second surface. The fingerprint sensor circuit may be formed in the first area. The insulating member may include a first portion arranged on the first area to cover the fingerprint sensor circuit and a second portion extending from the first portion to surround the third surface. The plurality of pads may be formed on the second area and may be respectively connected to the fingerprint sensor circuit through an electrical path formed in the substrate. The connection member may be connected to the plurality of pads and may include a portion located on the second area.

## Description

### [Technical Field]

The following descriptions relate to an electronic device including a fingerprint sensor.

### [Background Art]

A fingerprint sensor is widely used in biometric technology for user authentication or personal identification in various electronic devices. Such a fingerprint sensor may include, for example, a capacitive fingerprint sensor and an ultrasonic fingerprint sensor. The capacitive sensor may operate by measuring a difference in capacitance generated from a ridge and a valley of a fingerprint. The ultrasonic fingerprint sensor may operate by measuring a cycle in which ultrasonic waves emitted to a body of a user return.

The above-described information may be provided as a related art for a purpose of helping understanding of the present disclosure. No claim or determination is raised as to whether any of the above-described descriptions may be applied as a prior art related to the present disclosure.

### [Disclosure]

### [Technical Solution]

An electronic device according to an embodiment may include a substrate, fingerprint sensor circuitry, an insulating member, a plurality of pads, and a connecting member. The substrate may include a first surface including a first region and a second region spaced apart from the first region, a second surface opposite to the first surface, and a third surface extending from an edge of the first surface to an edge of the second surface. The fingerprint sensor circuitry may be formed on the first region. The insulating member may include a first portion disposed on the first region to cover the fingerprint sensor circuitry and a second portion extending from the first portion to surround the third surface. The plurality of pads may be formed on the second region and respectively connected to the fingerprint sensor circuitry via electrical paths formed in the substrate. The connecting member may be connected to the plurality of pads and include a portion located on the second region.

A manufacturing method of a fingerprint sensor package, according to an embodiment, may include patterning fingerprint sensor circuits including a plurality of pads on a wafer, forming a package by sealing the fingerprint sensor circuits with an insulating member, grinding the insulating member of the package by a first thickness, and removing a portion of the grounded insulating member by a second thickness to expose the plurality of pads. The second thickness may be less than the first thickness.

### [Description of the Drawings]

FIG. 1 is a diagram indicating an electronic device according to an embodiment.
FIG. 2 is an exploded perspective view of an electronic device according to an embodiment.
FIG. 3 is a cross-sectional view indicating a fingerprint sensor of an exemplary electronic device according to an embodiment.
FIG. 4 is a plan view indicating a fingerprint sensor of an exemplary electronic device according to an embodiment.
FIG. 5 illustrates a fingerprint sensor according to a comparative embodiment.
FIG. 6 is a cross-sectional view indicating a fingerprint sensor of an exemplary electronic device according to an embodiment.
FIG. 7 is a plan view indicating a fingerprint sensor of an exemplary electronic device according to an embodiment.
FIG. 8 illustrates a fingerprint sensor according to a comparative embodiment.
FIG. 9A is a flowchart indicating a manufacturing method of a fingerprint sensor according to an embodiment.
FIG. 9B is a flowchart indicating a manufacturing method of a fingerprint sensor according to an embodiment.
FIG. 10A is a diagram indicating a manufacturing method of a fingerprint sensor according to an embodiment.
FIG. 10B is a diagram indicating a manufacturing method of a fingerprint sensor according to an embodiment.
FIG. 11 is a block diagram of an electronic device in a network environment according to various embodiments.

### [Mode for Invention]

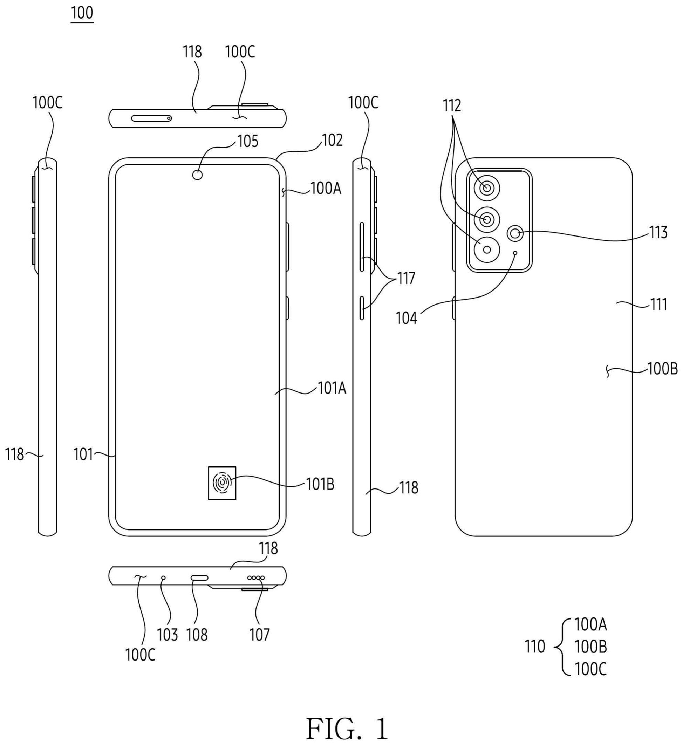

FIG. 1 is a diagram indicating an electronic device according to an embodiment.

Referring to FIG. 1, an electronic device 100 according to an embodiment may include a housing 110 forming an exterior of the electronic device 100. For example, the housing 110 may include a first surface (or a front surface) 100A, a second surface (or a rear surface) 100B, and a third surface (or a side surface) 100C surrounding a space between the first surface 100A and the second surface 100B. In an embodiment, the housing 110 may also refer to a structure forming at least a portion of the first surface 100A, the second surface 100B, and/or the third surface 100C.

The electronic device 100 according to an embodiment may include a substantially transparent front plate 102. In an embodiment, the front plate 102 may form at least a portion of the first surface 100A. In an embodiment, the front plate 102 may include, for example, a glass plate or a polymer plate that includes various coating layers, but is not limited thereto.

The electronic device 100 according to an embodiment may include a substantially opaque rear plate 111. In an embodiment, the rear plate 111 may form at least a portion of the second surface 100B. In an embodiment, the rear plate 111 may be formed by coated or colored glass, ceramic, polymer, metal (e.g., aluminum, stainless steel (STS), or magnesium), or a combination of at least two of the materials.

The electronic device 100 according to an embodiment may include a side bezel structure (e.g., a side member or a bracket) 118. In an embodiment, the side bezel structure 118 may form at least a portion of the third surface 100C of the electronic device 100 by being coupled with the front plate 102 and/or the rear plate 111. For example, the side bezel structure 118 may also form the entire third surface 100C of the electronic device 100, and for another example, the side bezel structure 118 may also form the third surface 100C of the electronic device 100 together with the front plate 102 and/or the rear plate 111.

Unlike the illustrated embodiment, in a case that the third surface 100C of the electronic device 100 is partially formed by the front plate 102 and/or the rear plate 111, the front plate 102 and/or the rear plate 111 may include a region that is bent toward the rear plate 111 and/or the front plate 102 at its edge and seamlessly extends. The extending region of the front plate 102 and/or the rear plate 111 may be located, for example, at both ends of a long edge of the electronic device 100, but is not limited by the above-described example.

In an embodiment, the side bezel structure 118 may include metal and/or polymer. In an embodiment, the rear plate 111 and the side bezel structure 118 may be integrally formed and may include the same material (e.g., a metallic material such as aluminum), but are not limited thereto. For example, the rear plate 111 and the side bezel structure 118 may be formed in separate configurations and/or may also include different materials.

In an embodiment, the electronic device 100 may include a display 101, audio modules 103, 104, and 107, a sensor module (not illustrated), camera modules 105, 112, and 113, a key input device 117, a light-emitting element (not illustrated), and a connector hole 108. In an embodiment, the electronic device 100 may omit at least one of the components (e.g., the key input device 117 or the light-emitting element (not illustrated)), or may additionally include another component.

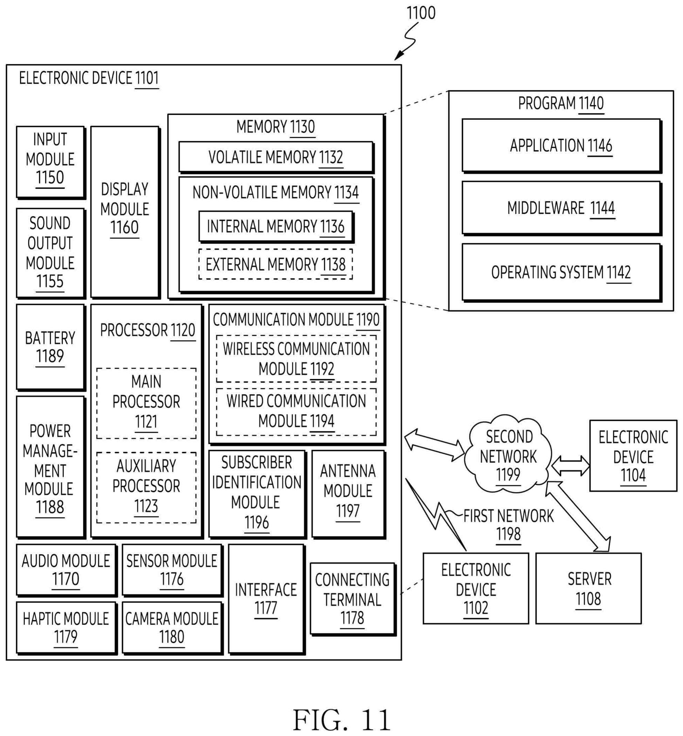

In an embodiment, the display 101 (e.g., a display module 1160 of FIG. 11) may be visually exposed through a significant portion of the front plate 102. For example, at least a portion of the display 101 may be visible through the front plate 102 forming the first surface 100A. The display 101 may be disposed on a back surface of the front plate 102.

In an embodiment, a shape of an outer periphery of the display 101 may be formed substantially the same as a shape of an outer periphery of the front plate 102 adjacent to the display 101. In an embodiment, in order to expand an area in which the display 101 is visually exposed, a distance between the outer periphery of the display 101 and the outer periphery of the front plate 102 may be formed substantially the same.

In an embodiment, the display 101 (or the first surface 100A of the electronic device 100) may include a screen display region 101A. In an embodiment, the display 101 may provide a user with visual information through the screen display region 101A. In the illustrated embodiment, when the first surface 100A is viewed from the front, it is illustrated that the screen display region 101A is spaced apart from an outer periphery of the first surface 100A and is located inside the first surface 100A, but it is not limited thereto. For example, when the first surface 100A is viewed from the front, at least a part of an edge of the screen display region 101A may also substantially coincide with an edge of the first surface 100A (or the front plate 102).

In an embodiment, the screen display region 101A may include a sensing region 101B configured to obtain biometric information of the user. Herein, a meaning of "the screen display region 101A includes the sensing region 101B" may be understood as that at least a portion of the sensing region 101B may be overlapped with the screen display region 101A. For example, the sensing region 101B may mean a region capable of displaying visual information by the display 101 like another region of the screen display region 101A and additionally obtaining the biometric information (e.g., a fingerprint) of the user. The sensing region 101B is illustrated to be formed in the screen display region 101A, but it is not limited thereto. For example, the sensing region 101B may also be formed in the key input device 117.

In an embodiment, the display 101 may include a region in which a first camera module 105 (e.g., a camera module 1180 of FIG. 11) is located. For example, an opening is formed in the region of the display 101, and the first camera module 105 (e.g., a punch hole camera) may be at least partially disposed in the opening to face the first surface 100A. In this case, the screen display region 101A may surround at least a part of an edge of the opening. In an embodiment, the first camera module 105 (e.g., an under display camera (UDC)) may be disposed under the display 101 to overlap the region of the display 101. In this case, the display 101 may provide the user with visual information through the region, and additionally, the first camera module 105 may obtain an image corresponding to a direction facing the first surface 100A through the region of the display 101.

In an embodiment, the display 101 may be coupled with or disposed adjacent to touch sensing circuitry, a pressure sensor capable of measuring intensity (pressure) of the touch, and/or a digitizer that detects a magnetic field type stylus pen.

In an embodiment, the audio modules 103, 104, and 107 (e.g., an audio module 1170 of FIG. 11) may include microphone holes 103 and 104 and a speaker hole 107.

In an embodiment, the microphone holes 103 and 104 may include a first microphone hole 103 formed in a partial region of the third surface 100C and a second microphone hole 104 formed in a partial region of the second surface 100B. A microphone (not illustrated) for obtaining external sound may be disposed inside the microphone holes 103 and 104. The microphone may include a plurality of microphones to sense a direction of sound, but is not limited thereto.

In an embodiment, the second microphone hole 104 formed in the partial region of the second surface 100B may be disposed to be adjacent to the camera modules 105, 112, and 113. For example, the second microphone hole 104 may obtain sound according to an operation of the camera modules 105, 112, and 113. However, it is not limited thereto.

In an embodiment, the speaker hole 107 may include an external speaker hole 107 and a call receiver hole (not illustrated). The external speaker hole 107 may be formed in a portion of the third surface 100C of the electronic device 100. In an embodiment, the external speaker hole 107 may be integrated into the microphone hole 103, and the speaker hole 107 and the microphone hole 103 may be implemented as one hole. Although not illustrated, the call receiver hole (not illustrated) may be formed on another portion of the third surface 100C. For example, the call receiver hole may be formed on an opposite side of the external speaker hole 107 on the third surface 100C. For example, based on the illustration of FIG. 1, the external speaker hole 107 may be formed on the third surface 100C corresponding to a lower end of the electronic device 100, and the call receiver hole may be formed on the third surface 100C corresponding to an upper end of the electronic device 100. However, it is not limited thereto, and in another embodiment, the call receiver hole may also be formed at a location other than the third surface 100C. For example, the call receiver hole may also be formed by a space separated between the front plate 102 (or the display 101) and the side bezel structure 118.

In an embodiment, the electronic device 100 may include at least one speaker (not illustrated) configured to output sound to the outside of the housing 110 through the external speaker hole 107 and/or the call receiver hole (not illustrated).

In an embodiment, the sensor module (not illustrated) (e.g., a sensor module 1176 of FIG. 11) may generate an electrical signal or a data value corresponding to an operating state inside the electronic device 100 or an external environmental state. For example, the sensor module may include at least one of a proximity sensor, an HRM sensor, a fingerprint sensor, a gesture sensor, a gyro sensor, a barometric sensor, a magnetic sensor, an acceleration sensor, a grip sensor, a color sensor, an infrared (IR) sensor, a biometric sensor, a temperature sensor, a humidity sensor, or an illuminance sensor.

In an embodiment, the camera modules 105, 112, and 113 (e.g., the camera module 1180 of FIG. 11) may include the first camera module 105 disposed to face the first surface 100A of the electronic device 100, a second camera module 112 disposed to face the second surface 100B, and a flash 113.

In an embodiment, the second camera module 112 may include a plurality of cameras (e.g., a dual camera, a triple camera, or a quad camera). However, the second camera module 112 is not necessarily limited to including the plurality of cameras, and may also include one camera.

In an embodiment, the first camera module 105 and the second camera module 112 may include one or more lenses, an image sensor, and/or an image signal processor.

In an embodiment, the flash 113 may include, for example, a light-emitting diode or a xenon lamp. In an embodiment, two or more lenses (an infrared camera, and a wide-angle and telephoto lens) and image sensors may be disposed on one surface of the electronic device 100.

In an embodiment, the key input device 117 (e.g., an input module 1150 of FIG. 11) may be disposed on the third surface 100C of the electronic device 100. In an embodiment, the electronic device 100 may not include a portion or all of the key input device 117, and the key input device 117 that is not included may be implemented in another form, such as a soft key, on the display 101.

In an embodiment, the connector hole 108 may be formed on the third surface 100C of the electronic device 100 such that a connector of an external device may be accommodated. A connecting terminal (e.g., a connecting terminal 1178 of FIG. 11) electrically connected with the connector of the external device may be disposed in the connector hole 108. The electronic device 100 according to an embodiment may include an interface module (e.g., an interface 1177 of FIG. 11) for processing an electrical signal transmitted and received through the connecting terminal.

In an embodiment, the electronic device 100 may include the light-emitting element (not illustrated). For example, the light-emitting element (not illustrated) may be disposed on the first surface 100A of the housing 110. The light-emitting element (not illustrated) may provide state information of the electronic device 100 in a form of light. In an embodiment, the light-emitting element (not illustrated) may provide a light source linked with an operation of the first camera module 105. For example, the light-emitting element (not illustrated) may include an LED, an IR LED, and/or a xenon lamp.

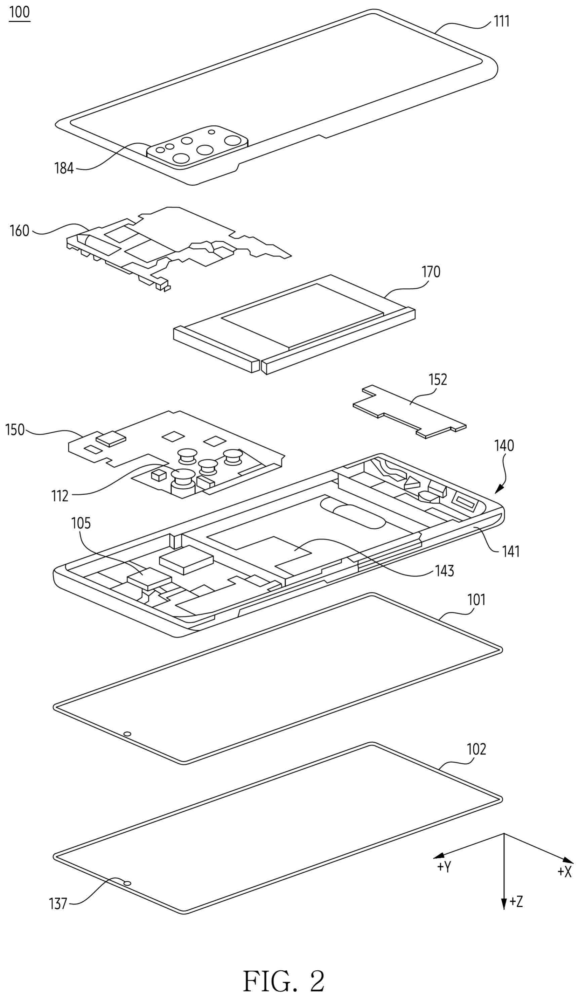

FIG. 2 is an exploded perspective view of an electronic device according to an embodiment. Hereinafter, an overlapping description of a configuration having the same reference numerals as the above-described configuration will be omitted. Referring to FIG. 2, an electronic device 100 according to an embodiment may include a frame structure 140, a first printed circuit board 150, a second printed circuit board 152, a cover plate 160, and a battery 170.

In an embodiment, the frame structure 140 (e.g., the side bezel structure 118 of FIG. 1) may include a sidewall 141 forming an exterior (e.g., the third surface 100C of FIG. 1) of the electronic device 100 and a support portion 143 extending inward from the sidewall 141. In an embodiment, the frame structure 140 may be disposed between a display 101 and a rear plate 111. In an embodiment, the sidewall 141 of the frame structure 140 may surround a space between the rear plate 111 and a front plate 102 (and/or the display 101). The support portion 143 of the frame structure 140 may extend from the sidewall 141 in the space.

In an embodiment, the frame structure 140 may support or accommodate other components included in the electronic device 100. For example, the display 101 may be disposed on a surface of the frame structure 140 toward a direction (e.g., a +z direction). The display 101 may be supported by the support portion 143 of the frame structure 140. The first printed circuit board 150, the second printed circuit board 152, the battery 170, and a second camera module 112 may be disposed on another surface of the frame structure 140 toward an opposite direction (e.g., a -z direction) to the direction. The first printed circuit board 150, the second printed circuit board 152, the battery 170, and the second camera module 112 may be respectively seated in a recess defined by the sidewall 141 and/or the support portion 143 of the frame structure 140.

In an embodiment, the first printed circuit board 150, the second printed circuit board 152, and the battery 170 may be coupled with the frame structure 140, respectively. For example, the first printed circuit board 150 and the second printed circuit board 152 may be fixedly disposed on the frame structure 140 through a coupling member such as a screw. For example, the battery 170 may be fixedly disposed on the frame structure 140 through an adhesive member (e.g., a double-sided tape). However, it is not limited by the above-described example.

In an embodiment, the cover plate 160 may be disposed between the first printed circuit board 150 and the rear plate 111. In an embodiment, the cover plate 160 may be disposed on the first printed circuit board 150. For example, the cover plate 160 may be disposed on a surface of the first printed circuit board 150 toward the -z direction.

In an embodiment, the cover plate 160 may at least partially overlap the first printed circuit board 150 based on a z-axis. In an embodiment, the cover plate 160 may cover at least a partial region of the first printed circuit board 150. Accordingly, the cover plate 160 may protect the first printed circuit board 150 from a physical impact or prevent detachment of a connector coupled to the first printed circuit board 150.

In an embodiment, the cover plate 160 may be fixedly disposed on the first printed circuit board 150 through a coupling member (e.g., a screw), or may be coupled to the frame structure 140 together with the first printed circuit board 150 through the coupling member.

In an embodiment, the display 101 may be disposed between the frame structure 140 and the front plate 102. For example, the front plate 102 may be disposed on a side (e.g., in the +z direction) of the display 101, and the frame structure 140 may be disposed on another side (e.g., in the -z direction).

In an embodiment, the front plate 102 may be coupled with the display 101. For example, the front plate 102 and the display 101 may be attached to each other through an optical adhesive member (e.g., an optically clear adhesive (OCA) or an optically clear resin (OCR)) interposed therebetween.

In an embodiment, the front plate 102 may be coupled with the frame structure 140. For example, the front plate 102 may include, when viewed in a z-axis direction, an outer portion extending outside the display 101 and may be attached with the frame structure 140 through an adhesive member (e.g., a double-sided tape) disposed between the outer portion of the front plate 102 and the frame structure 140 (e.g., the sidewall 141). However, it is not limited by the above-described example.

In an embodiment, the first printed circuit board 150 and/or the second printed circuit board 152 may be equipped with a processor (e.g., a processor 1120 of FIG. 11), memory (e.g., memory 1130 of FIG. 11), and/or an interface (e.g., an interface 1177 of FIG. 11). The processor may include, for example, one or more of a central processing unit, an application processor, a graphic processing unit, an image signal processor, a sensor hub processor, or a communication processor. The memory may include, for example, volatile memory or non-volatile memory. The interface may include, for example, a high definition multimedia interface (HDMI), a universal serial bus (USB) interface, an SD card interface, and/or an audio interface. The interface may electrically or physically connect the electronic device 100 to an external electronic device, and may include a USB connector, an SD card/MMC connector, or an audio connector. In an embodiment, the first printed circuit board 150 and the second printed circuit board 152 may be operatively or electrically connected to each other through a connecting member (e.g., a flexible printed circuit board).

In an embodiment, the battery 170 (e.g., a battery 1189 of FIG. 11) may supply power to at least one component of the electronic device 100. For example, the battery 170 may include a rechargeable secondary battery or a fuel cell.

The electronic device 100 according to an embodiment may include an antenna module (not illustrated) (e.g., an antenna module 1197 of FIG. 11). In an embodiment, the antenna module may be disposed between the rear plate 111 and the battery 170. The antenna module may include, for example, a near field communication (NFC) antenna, a wireless charging antenna, and/or a magnetic secure transmission (MST) antenna. The antenna module may, for example, perform short-range communication with an external device or wirelessly transmit and receive power with the external device.

In an embodiment, a first camera module 105 (e.g., a front camera) may be disposed in at least a portion (e.g., the support portion 143) of the frame structure 140 such that a lens may receive external light through a partial region (e.g., a camera region 137) of the front plate 102 (e.g., the front surface 100A of FIG. 1).

In an embodiment, the second camera module 112 (e.g., a rear camera) may be disposed between the frame structure 140 and the rear plate 111. In an embodiment, the second camera module 112 may be electrically connected to the first printed circuit board 150 through a connecting member (e.g., a connector). In an embodiment, the second camera module 112 may be disposed such that a lens may receive external light through a camera region 184 of the rear plate 111 of the electronic device 100.

In an embodiment, the camera region 184 may be formed on a surface (e.g., the rear surface 100B of FIG. 1) of the rear plate 111. In an embodiment, the camera region 184 may be formed to be at least partially transparent such that the external light may be incident on the lens of the second camera module 112. In an embodiment, at least a portion of the camera region 184 may protrude from the surface of the rear plate 111 to a predetermined height. However, it is not limited thereto, and in another embodiment, the camera region 184 may also form substantially the same plane as the surface of the rear plate 111.

In an embodiment, a housing 110 of the electronic device 100 may mean a configuration or a structure forming at least a portion of the exterior of the electronic device 100. In this regard, at least a portion of the front plate 102, the frame structure 140, and/or the rear plate 111 forming the exterior of the electronic device 100 may be referred to as the housing 110 of the electronic device 100.

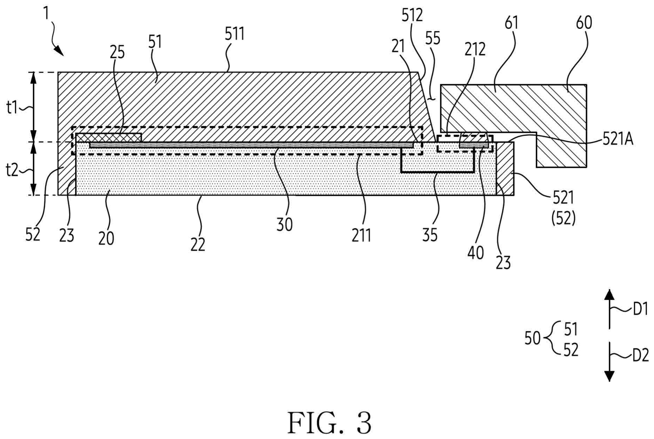

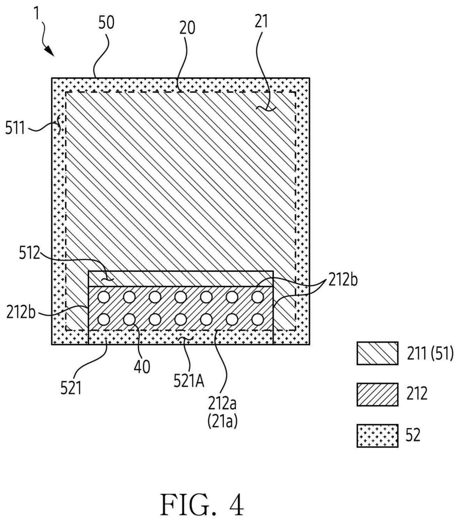

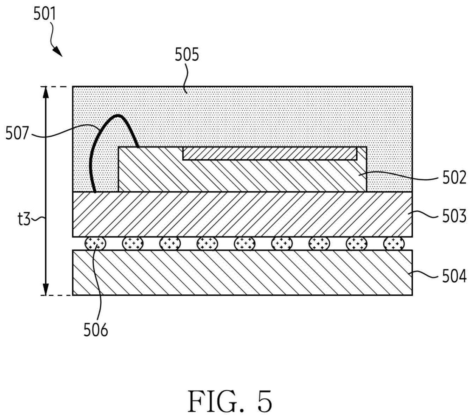

FIG. 3 is a cross-sectional view indicating a fingerprint sensor of an exemplary electronic device according to an embodiment. FIG. 4 is a plan view indicating a fingerprint sensor of an exemplary electronic device according to an embodiment. FIG. 5 illustrates a fingerprint sensor according to a comparative embodiment.

Referring to FIGS. 3 and 4, an electronic device (e.g., the electronic device 100 of FIG. 2) according to an embodiment may include a fingerprint sensor 1 and a connecting member 60. In an embodiment, the fingerprint sensor 1 may include a substrate 20, sensor circuitry 30, a plurality of pads 40, and an insulating member 50.

In an embodiment, the substrate 20 may include a first surface 21, a second surface 22, and a third surface 23. The first surface 21 may be opposite to the second surface 22. For example, the first surface 21 may face a first direction D1, and the second surface 22 may face a second direction D2 opposite to the first direction D1. The first direction D1 and the second direction D2 may be a direction perpendicular to the first surface 21 and the second surface 22. The third surface 23 may extend from an edge of the first surface 21 to an edge of the second surface 22. The third surface 23 may face a direction perpendicular to the first direction D1 and the second direction D2.

In an embodiment, the first surface 21 of the substrate 20 may include a first region 211 and a second region 212 spaced apart from the first region 211. The sensor circuitry 30 may be formed on the first region 211. For example, the sensor circuitry 30 may be disposed on the first region 211. For example, the sensor circuitry 30 may be attached onto the first region 211. The sensor circuitry 30 may include conductive patterns for detecting capacitance. The plurality of pads 40 may be formed on the second region 212. For example, the plurality of pads 40 may be exposed through the second region 212. The plurality of pads 40 may be located within the second region 212. The plurality of pads 40 may be connected to the sensor circuitry 30. For example, each of the plurality of pads 40 may be connected to the sensor circuitry 30. The plurality of pads 40 may be connected to the sensor circuitry 30 through an electrical path(s) 35 provided by the substrate 20. For example, the plurality of pads 40 may be electrically connected to the sensor circuitry 30 through conductive wires formed on and/or in the substrate 20. The conductive patterns and the plurality of pads 40 of the sensor circuitry 30 may be formed of a conductive material (e.g., conductive metal). The plurality of pads 40 may be referred to as conductive regions, metal pads, or conductive pads. The fingerprint sensor 1 according to an embodiment may further include an insulating layer 25 formed on the first surface 21 of the substrate 20.

In an embodiment, the second region 212 may include edges 212a and 212b defining an area of the second region 212. For example, the edges 212a and 212b of the second region 212 may include a first section (or a first edge) 212a forming a part 21a of the edge of the first surface 21 and a second section (or a second edge) 212b extending from one end to another end of the first section 212a. A shape of the second region 212 defined by the edges 212a and 212b may be a quadrangle, but is not limited thereto.

In an embodiment, the insulating member 50 may include a first portion 51 and a second portion 52. The first portion 51 may be disposed on a portion of the first surface 21 of the substrate 20. For example, the first portion 51 may be disposed on the first region 211 of the first surface 21 to cover the sensor circuitry 30. As the insulating member 50 seals the sensor circuitry 30, the sensor circuitry 30 may be protected. For example, the insulating member 50 may protect the sensor circuitry 30 from a physical impact, corrosion, circuit shorting, and overheating. The second portion 52 extending from the first portion 51 may surround the third surface 23 of the substrate 20. The second portion 52 may be a portion that does not overlap the substrate 20 when viewed in the first direction D1. In an embodiment, the insulating member 50 may not be formed on the second region 212 of the substrate 20.

The insulating member 50 may include, for example, an epoxy molding compound (EMC), but is not limited thereto. The insulating member 50 may be referred to as a nonconductive member, an encapsulant, or an encapsulation member.

In an embodiment, the insulating member 50 may include an upper surface 511. The upper surface 511 may be spaced apart from the first surface 21 of the substrate 20. For example, the upper surface 511 may be spaced apart from the first surface 21 of the substrate 20 in the first direction D1. The upper surface 511 may be substantially parallel to the first surface 21 of the substrate 20, but is not limited thereto. The upper surface 511 may be at least partially formed by the first portion 51 of the insulating member 50. For example, the upper surface 511 may also be formed together by the first portion 51 and the second portion 52 of the insulating member 50, or may also be formed only by the first portion 51. In an embodiment, a thickness t1 of the first portion 51 of the insulating member 50 may be 30 µm to 60 µm, but is not limited thereto. The thickness t1 may be a distance from the first surface 21 of the substrate 20 to the upper surface 511 of the insulating member 50 based on the first direction D1. Also, a thickness t2 of the substrate 20 may be 20 µm to 50 µm, but is not limited thereto.

In an embodiment, the insulating member 50 may include a side surface 512 extending from the second region 212. The side surface 512 may extend from a second section 212b of the second region 212 to an edge of the upper surface 511.

In an embodiment, the side surface 512 of the insulating member 50 may be inclined with respect to the first surface 21 of the substrate 20. For example, the side surface 512 of the insulating member 50 may extend, based on a direction parallel to the first surface 21, such that a distance from the second region 212 (or the plurality of pads 40) increases as a height of the insulating member 50 increases. However, it is not limited thereto, and at least a portion of the side surface 512 of the insulating member 50 may be perpendicular to the first surface 21 of the substrate 20. The side surface 512 of the insulating member 50 may be formed by the first portion 51, but is not limited thereto.

In an embodiment, the second portion 52 of the insulating member 50 may include a sub-portion 521. The sub-portion 521 may form a surface 521A extending from the first region 211. For example, the surface 521A of the sub-portion 521 may extend from the first section 212a of the first region 211. The surface 521A of the sub-portion 521 may extend parallel to the first region 211. For example, the surface 521A may extend from the first region 211 without a step. For example, the surface 521A and the first region 211 may form one flat region. However, it is not limited by the above-described example. For example, the surface 521A may extend so as to be inclined with respect to the first region 211.

In an embodiment, the fingerprint sensor 1 may include the substrate 20 and a concave portion 55 formed by the insulating member 50. The concave portion 55 may be defined by the side surface 512 and the surface 521A of the insulating member 50, and the second region 212 of the substrate 20. The concave portion 55 may be referred to as a recess, an indentation, or a groove.

In an embodiment, the connecting member 60 may include a portion 61. The portion 61 of the connecting member 60 may be accommodated in the concave portion 55. The portion 61 of the connecting member 60 may be located on the second region 212 of the substrate 20. For example, the portion 61 of the connecting member 60 may be located between an imaginary plane including the upper surface 511 of the insulating member 50 and the second region 212 of the substrate 20. In an embodiment, the portion 61 of the connecting member 60 may be a portion overlapping the substrate 20 based on the first direction D1. For example, the portion 61 of the connecting member 60 may be a portion overlapping the second region 212 of the substrate 20 based on the first direction D1. The portion 61 may form one end of the connecting member 60, but is not limited thereto. The portion 61 of the connecting member 60 may be electrically connected to the plurality of pads 40. Additionally, an adhesive member (not illustrated) (e.g., epoxy) for attaching the portion 61 of the connecting member 60 to the second region 212 may be filled in the concave portion 55.

In an embodiment, pads formed on the portion 61 of the connecting member 60 may be respectively bonded to the plurality of pads 40 of the substrate 20. For example, the pads of the connecting member 60 may be soldered to the plurality of pads 40 through a conductive member such as a solder ball, or bonded to the plurality of pads 40 through an anisotropic conductive film (ACF). However, it is not limited by the above-described example, and bonding between the connecting member 60 and the plurality of pads 40 may be performed through various methods.

In an embodiment, the connecting member 60 may include a printed circuit board, a flexible printed circuit board, a rigid-flexible printed circuit board, an interposer, or a package substrate.

In an embodiment, the fingerprint sensor 1 may be operatively or communicatively connected to a processor (e.g., a processor 1120 of FIG. 11) of the electronic device. For example, the fingerprint sensor 1 may be connected to the printed circuit board (e.g., the first printed circuit board 150 or the second printed circuit board 152 of FIG. 2) of the electronic device through the connecting member 60. The fingerprint sensor 1 may be electrically connected to the processor on the printed circuit board through an electrical path provided by the printed circuit board.

In an embodiment, the sensor circuitry 30 of the fingerprint sensor 1 may detect capacitance from a finger of a user in contact with or close to the upper surface 511 of the insulating member 50. For example, the fingerprint sensor 1 may detect a difference in capacitance between a valley and a ridge on epidermis of the finger of the user. The fingerprint sensor 1 or the processor connected to the fingerprint sensor 1 may obtain information (e.g., fingerprint image information) on a fingerprint of the user based on the detected difference in capacitance.

In an embodiment, the fingerprint sensor 1 may be coupled to a key button (e.g., the key input device 117 of FIG. 1) installed in a housing (e.g., the housing 110 of FIG. 1) to obtain fingerprint information of the user. For example, as the upper surface 511 is at least partially exposed through the key button, the fingerprint sensor 1 may detect the fingerprint information of the user in contact with the upper surface 511 . In this case, optionally or additionally, a layer (e.g., an ink layer) for implementing a color may be formed on the upper surface 511 of the insulating member 50.

In an embodiment, in a case that the fingerprint sensor 1 is coupled to the key button, a dome switch for generating an electrical signal by pressing the key button may be disposed below the fingerprint sensor 1. The dome switch may be disposed below the second surface 22 of the substrate 20 (e.g., in the second direction D2), for example. In a case that the user presses the key button, the dome switch may generate an electrical signal by being pressed by the second surface 22 of the substrate 20.

Referring to FIG. 5, a fingerprint sensor 501 according to the comparative embodiment has a structure in which sensor circuitry 502 is disposed on a substrate 503 and a connecting substrate 504 below the substrate 503 is connected to the substrate 503 with a solder ball 506. That is, since the fingerprint sensor 501 of the comparative embodiment has a vertical connection structure, it is difficult to reduce a thickness t3 of the sensor. The thickness t3 of the sensor of the comparative embodiment may be 1 mm or more. In addition, since the sensor circuitry 502 of the comparative embodiment is bonded through a wire 507, it is also difficult to reduce a thickness of an insulating member 505 for sealing both the sensor circuitry 502 and the wire 507.

On the other hand, referring to FIGS. 3 and 4, in the fingerprint sensor 1 according to an embodiment, both the sensor circuitry 30 and the plurality of pads 40 may be formed on the first surface 21 of the substrate 20. The connecting member 60 may be bonded on the first surface 21 on which the plurality of pads 40 are formed. That is, since the fingerprint sensor 1 according to an embodiment has a horizontal connection structure, unlike the comparative embodiment, a thickness of the fingerprint sensor 1 may be reduced. Specifically, since the fingerprint sensor 1 according to an embodiment does not include the solder ball 506 and the connecting substrate 504 below the substrate 20 (e.g., in the second direction D2), a thickness occupied by the solder ball 506 and the connecting substrate 504 may be reduced. In addition, since the fingerprint sensor 1 according to an embodiment does not include wire bonding of the sensor circuitry 30, the thickness of the insulating member 505 to prevent exposure of the wire 507 may not be required. Accordingly, a thickness of the insulating member 50 may be reduced. In addition, since the fingerprint sensor 1 according to an embodiment has a simpler structure than the comparative embodiment, it may reduce parts and process costs.

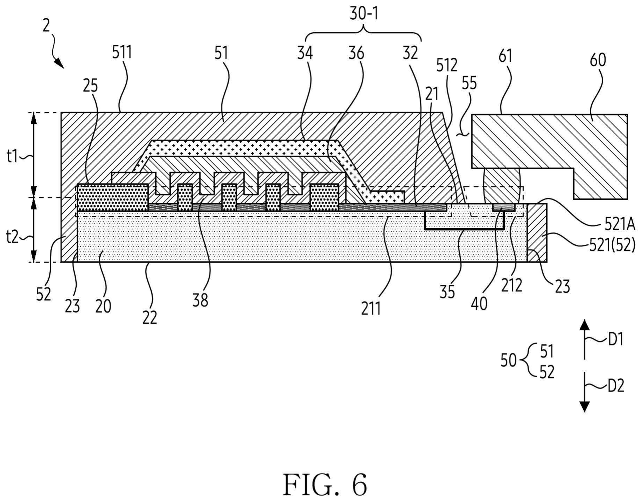

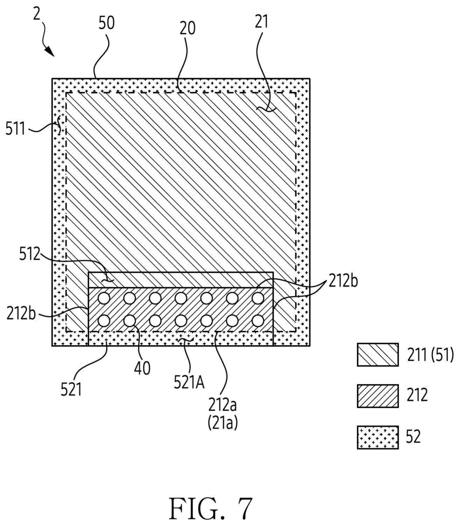

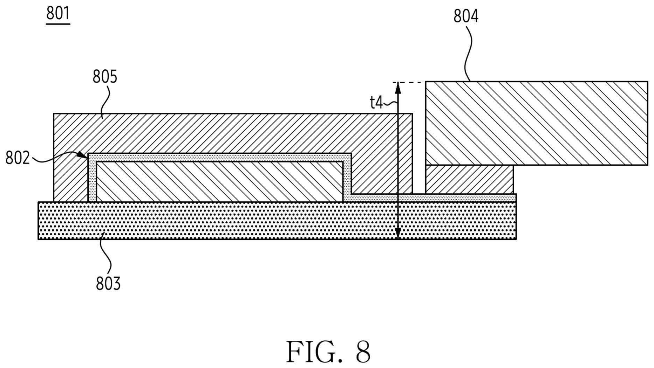

FIG. 6 is a cross-sectional view indicating a fingerprint sensor of an exemplary electronic device according to an embodiment. FIG. 7 is a plan view indicating a fingerprint sensor of an exemplary electronic device according to an embodiment. FIG. 8 illustrates a fingerprint sensor according to a comparative embodiment.

Referring to FIGS. 6 and 7, the electronic device according to an embodiment may include a fingerprint sensor 2. In an embodiment, the fingerprint sensor 2 may include sensor circuitry 30-1. The sensor circuitry 30-1 may be formed on a first surface 21 of a substrate 20. For example, the sensor circuitry 30-1 may be formed on a first region 211 of the first surface 21. The sensor circuitry 30-1 may be disposed on the first region 211. The sensor circuitry 30-1 may be attached onto the first region 211. The sensor circuitry 30-1 on the first region 211 may be sealed by being covered by an insulating member 50.

In an embodiment, the sensor circuitry 30-1 may be connected to a plurality of pads 40. For example, the sensor circuitry 30-1 may be respectively connected to the plurality of pads 40. The sensor circuitry 30-1 may be connected to the plurality of pads 40 via electrical paths 35 provided by the substrate 20. The electrical paths 35 may be provided on and/or in the substrate 20.

In an embodiment, the sensor circuitry 30-1 may include a first conductive layer 32, a second conductive layer 34, and a piezoelectric layer 36. The first conductive layer 32 may be formed on the first surface 21 of the substrate 20. The piezoelectric layer 36 may be formed between the first conductive layer 32 and the second conductive layer 34. The second conductive layer 34 may be formed on the piezoelectric layer 36. The first conductive layer 32 and the second conductive layer 34 may be electrically connected to the plurality of pads 40.

In an embodiment, the first conductive layer 32 and the piezoelectric layer 36 may be configured to generate ultrasonic waves. The second conductive layer 34 and the piezoelectric layer 36 may be configured to receive and/or detect the ultrasonic waves. The first conductive layer 32 and the second conductive layer 34 may be referred to as first and second conductive electrodes or first and second conductive patterns.

In an embodiment, the first conductive layer 32 and the second conductive layer 34 may be formed of a conductive material (e.g., conductive metal). The piezoelectric layer 36 may include a piezoelectric material. For example, the piezoelectric layer 36 may be formed of lead zirconate titanate (PZT), polyvinylidene fluoride (PVDF), or zinc oxide (ZnO), but is not limited thereto. The fingerprint sensor 2 may include a primer layer 38, which is a seed layer for forming the piezoelectric layer 36.

In an embodiment, the fingerprint sensor 2 may be operatively or communicatively connected to the processor. For example, the fingerprint sensor 2 may be connected to the printed circuit board through a connecting member 60. The fingerprint sensor 2 may be electrically connected to the processor through an electrical path provided by the printed circuit board.

In an embodiment, the sensor circuitry 30-1 of the fingerprint sensor 2 may detect a fingerprint of a finger of a user in contact with or close to a second surface 22 of the substrate 20. For example, the first conductive layer 32 and the piezoelectric layer 36 may transmit ultrasonic waves to a finger of the user in contact with or close to the first surface 21 of the substrate 20. The second conductive layer 34 and the piezoelectric layer 36 may receive or detect at least a portion of the ultrasonic waves reflected by the finger of the user. The processor connected to the fingerprint sensor 2 or the fingerprint sensor 2 may obtain information (e.g., fingerprint image information) on a fingerprint of the user based on a time at which the ultrasonic waves are reflected on a body of the user and returned.

Similar to the fingerprint sensor 1, the fingerprint sensor 2 may be coupled to the key button to obtain fingerprint information of the user through the key button. For example, the fingerprint sensor 2 may be coupled to the key button such that the second surface 22 of the substrate 20 is attached to the key button or at least partially exposed through the key button. In a case that the fingerprint sensor 2 is coupled to the key button, a dome switch that generates an electrical signal by pressing the key button may be disposed below the fingerprint sensor 2. For example, the dome switch may be disposed above an upper surface 511 of the insulating member 50 of the substrate 20 (e.g., in a first direction D1). In a case that the user presses the key button, the dome switch may generate an electrical signal by being pressed by the upper surface 511 of the insulating member 50.

Alternatively or additionally, the fingerprint sensor 2 according to an embodiment may be coupled to a display (e.g., the display 101 of FIG. 1). For example, the fingerprint sensor 2 may be attached to a back surface of the display. The fingerprint sensor 2 coupled to the display may detect a fingerprint of a finger of the user in contact with a sensing region (e.g., the sensing region 101B of FIG. 1).

In an embodiment, the fingerprint sensor 1 and/or the fingerprint sensor 2 may be referred to as a sensor unit, a sensor module, a fingerprint sensor module, a sensor package, or a fingerprint sensor package.

Referring to FIG. 8, in a fingerprint sensor 801 according to the comparative embodiment, sensor circuitry 802 for generating and detecting ultrasonic waves is formed on a substrate 803. A backer layer 805 covering the sensor circuitry 802 is formed of a die attach film or ink. A connecting substrate 804 is connected with the sensor circuitry 802 by being disposed on the substrate 803. A thickness t4 of the fingerprint sensor 801 may be 160 µm or more. The thickness t4 of the fingerprint sensor 801 may be a distance from a lower surface of the substrate 803 to an uppermost end of the connecting substrate 804.

Referring to FIGS. 6, 7, and 8, since the substrate 803 of the fingerprint sensor 801 according to the comparative embodiment is exposed, the substrate 803 having weak rigidity may be broken or chemically damaged. Although the backer layer 805 covers the sensor circuitry 802, since it is formed of a thin film, it may be difficult to protect the sensor circuitry 802 from physical damage. On the other hand, the substrate 20 of the fingerprint sensor 2 and the sensor circuitry 30-1 on the substrate 20 according to an embodiment may be protected from physical damage by being surrounded by the insulating member 50.

In the comparative embodiment, since the connecting substrate 804 disposed on the substrate 803 is formed thicker than the sensor circuitry 802 and the backer layer 805, mountability of the fingerprint sensor 801 may be deteriorated. On the other hand, since a portion 61 to which the connecting member 60 of the fingerprint sensor 2 according to an embodiment is connected to the substrate 20 is located below the upper surface 511 of the insulating member 50 (e.g., in a second direction D2), it may not affect mountability.

In addition, since the fingerprint sensor 801 of the comparative embodiment is difficult to adjust physical properties of the substrate 803, the sensor circuitry 802, and the backer layer 805, it may be difficult to adjust warpage characteristics of the substrate 803. On the other hand, the fingerprint sensor 2 according to an embodiment may adjust the warpage characteristics by adjusting physical properties (e.g., a resin of an epoxy molding compound and filler contents) of the insulating member 50 surrounding the substrate 20 and the sensor circuitry 30-1. The fingerprint sensor 2 according to an embodiment may improve the warpage characteristics by adjusting the physical properties of the insulating member 50. Accordingly, visibility and adhesion of the fingerprint sensor 2 may be improved.

An electronic device (e.g., the electronic device 100 of FIG. 1) according to an embodiment may include a substrate (e.g., the substrate 20 of FIG. 3 or 6), fingerprint sensor circuitry (e.g., the sensor circuitry 30 of FIG. 3 or the sensor circuitry 30-1 of FIG. 6), an insulating member (e.g., the insulating member 50 of FIG. 3 or 6), a plurality of pads (e.g., the plurality of pads 40 of FIG. 3 or 6), and a connecting member (e.g., the connecting member 60 of FIG. 3 or 6). The substrate may include a first surface (e.g., the first surface 21 of FIG. 3 or 6) including a first region (e.g., the first region 211 of FIG. 3 or 6) and a second region (e.g., the second region 212 of FIG. 3 or 6) spaced apart from the first region, a second surface (e.g., the second surface 22 of FIG. 3 or 6) opposite to the first surface, and a third surface (e.g., the third surface 23 of FIG. 3 or 6) extending from an edge of the first surface to an edge of the second surface. The fingerprint sensor circuitry may be formed on the first region. The insulating member may include a first portion (e.g., the first portion 51 of FIG. 3 or 6) disposed on the first region to cover the fingerprint sensor circuitry, and a second portion (e.g., the second portion 52 of FIGS. 3 or 6) extending from the first portion to surround the third surface. The plurality of pads may be formed on the second region and respectively connected to the fingerprint sensor circuitry via electrical paths (e.g., the electrical paths 35 of FIG. 3 or 6) formed in the substrate. The connecting member may include a portion (e.g., the portion 61 of FIG. 3 or 6) connected to the plurality of pads and located on the second region.

In an embodiment, the insulating member may not be formed on the second region.

In an embodiment, the first surface of the substrate may face a first direction (e.g., the first direction D1 of FIG. 3 or 6). The first portion of the insulating member may include an upper surface (e.g., the upper surface 511 of FIGS. 3 or 6) spaced apart from the first surface of the substrate in the first direction. The portion of the connecting member may be located between the second region and an imaginary plane including the upper surface.

In an embodiment, the portion of the connecting member may be a portion overlapping the substrate based on the first direction.

In an embodiment, the second portion of the insulating member may include a sub-portion (e.g., the sub-portion 521 of FIG. 3 or 6). The second region may form a part (e.g., the part 21a of FIG. 4 or 7) of an edge of the first surface of the substrate. The sub-portion may form a surface (e.g., the surface 521A of FIG. 3 or 6) extending from the part of the edge of the first surface.

In an embodiment, the surface formed by the sub-portion may extend parallel to the first surface.

In an embodiment, the first surface of the substrate may face a first direction. The second region may include an edge (e.g., the second section 212b of FIG. 3 or 6) extending from one end to another end of the part of the edge of the first surface. The first portion of the insulating member may include an upper surface (e.g., the upper surface 511 of FIGS. 3 or 6) spaced apart from the first surface of the substrate in the first direction, and a side surface (e.g., the side surface 512 of FIGS. 3 or 6) extending from the edge of the second region to an edge of the upper surface.

In an embodiment, the side surface may be inclined with respect to the first surface.

In an embodiment, the side surface of the insulating member may be formed such that a distance from the plurality of pads increases based on a direction parallel to the first surface as the side surface approaches the upper surface.

The electronic device according to an embodiment may include a display (e.g., the display 101 of FIG. 1). The second surface of the substrate may be attached to the display.

The electronic device according to an embodiment may include a dome switch disposed below the second surface of the substrate.

In an embodiment, the insulating member may include an upper surface (e.g., the upper surface 511 of FIG. 3 or 6) exposed to the outside of the electronic device. The fingerprint sensor circuitry may be configured to detect capacitance with a part of a body of a user adjacent to the upper surface.

In an embodiment, the fingerprint sensor circuitry may be configured to transmit ultrasonic waves to a part of a body of a user through the second surface of the substrate. The fingerprint sensor circuitry may be configured to receive at least a portion of the ultrasonic waves reflected from the part of the body of the user.

In an embodiment, the fingerprint sensor circuitry may include a first conductive layer (e.g., the first conductive layer 32 of FIG. 6), a second conductive layer (e.g., the second conductive layer 34 of FIG. 6), and a piezoelectric layer (e.g., the piezoelectric layer 36 of FIG. 6) connected to the first conductive layer and the second conductive layer. The first conductive layer and the piezoelectric layer may be configured to generate the ultrasonic waves. The second conductive layer and the piezoelectric layer may be configured to receive the at least a portion of the ultrasound waves.

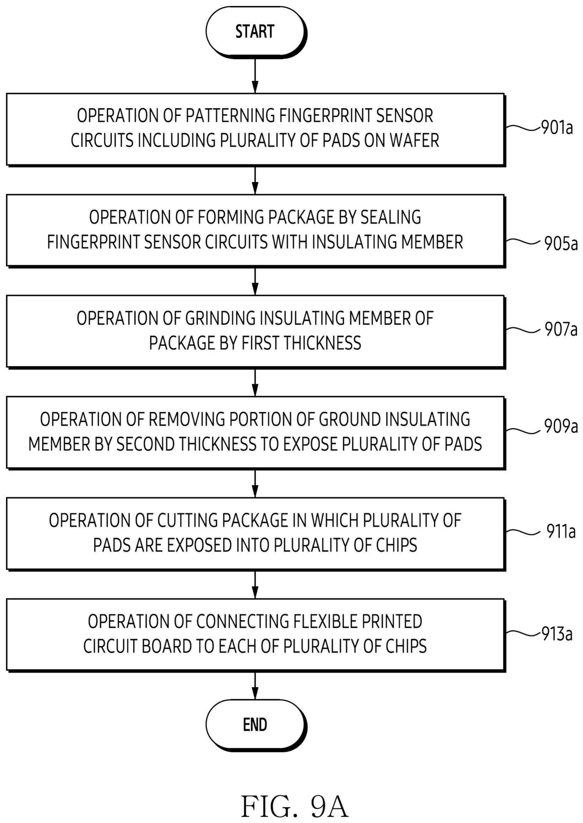

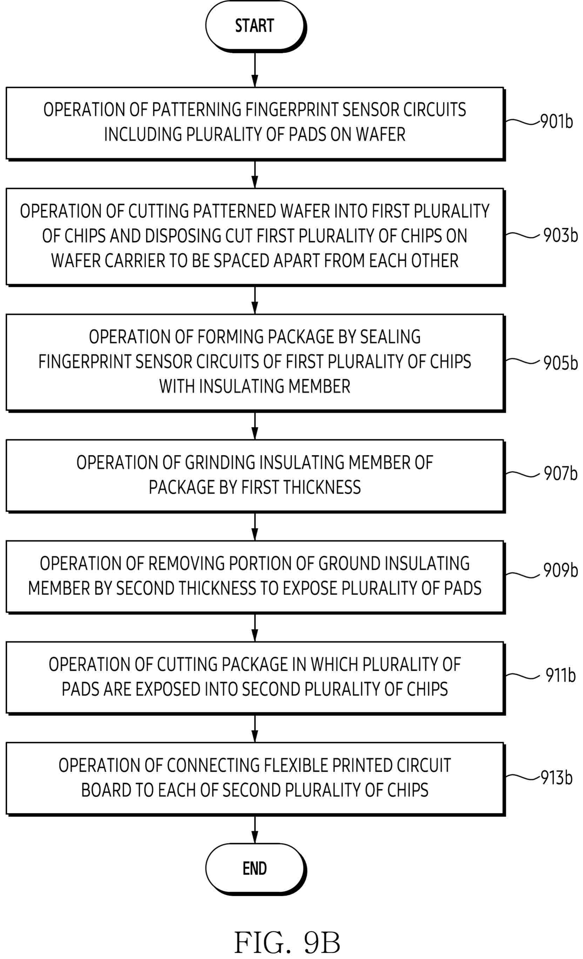

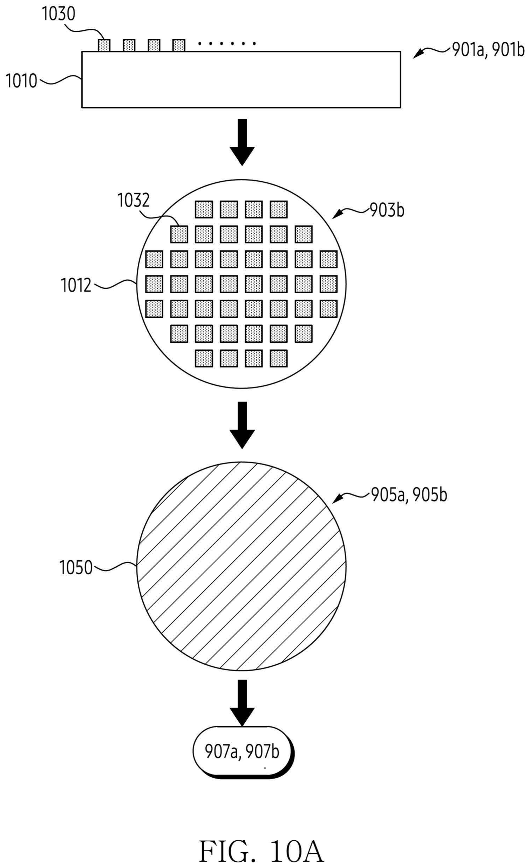

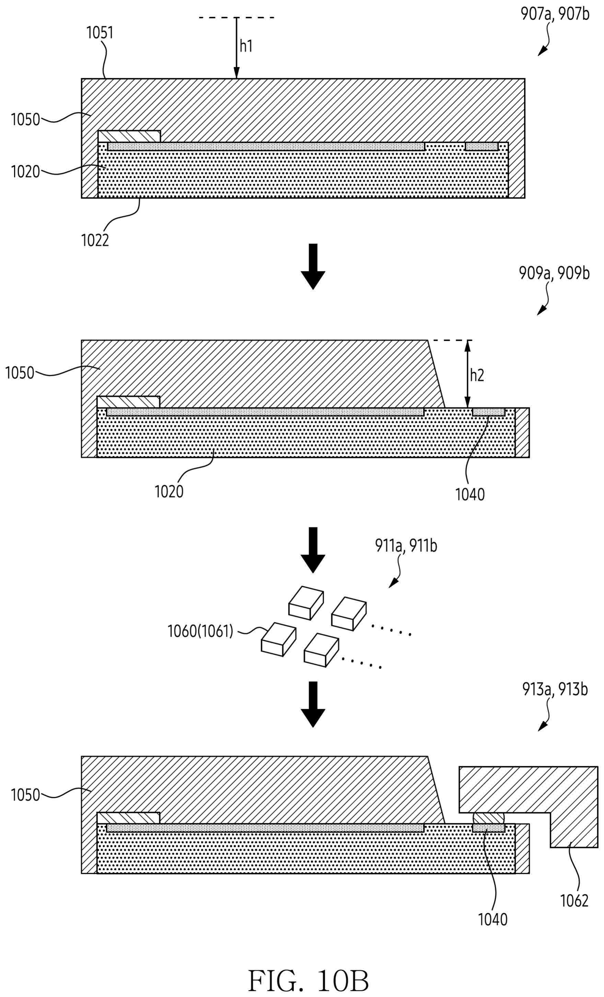

FIGS. 9A and 9B are a flowchart indicating a manufacturing method of a fingerprint sensor according to an embodiment. FIGS. 10A and 10B are a diagram indicating a manufacturing method of a fingerprint sensor according to an embodiment.

The manufacturing method of the fingerprint sensor (e.g., the fingerprint sensor 1 of FIG. 3) according to an embodiment will be described with reference to FIGS. 9A, 10A, and 10B. In the manufacturing method of FIG. 9A, operation 903b of FIG. 10A is not performed, and operation 905a may be performed after operation 901a of FIG. 10A is performed.

In the operation 901a, an operation of patterning fingerprint sensor circuits including a plurality of pads on a wafer may be performed. For example, sensor circuits 1030 including the plurality of pads (e.g., the plurality of pads 40 of FIG. 3) may be formed on the wafer 1010. The sensor circuits 1030 may include, for example, the sensor circuitry 30 of FIG. 3. The wafer 1010 may include a silicon wafer, but is not limited thereto. The operation 901a may be referred to as a patterning process.

In the operation 905a, an operation of forming a package by sealing the fingerprint sensor circuits with an insulating member may be performed. For example, the package may be formed by covering the sensor circuits 1030 on a wafer carrier 1012 with an insulating member 1050 (e.g., the insulating member 50 of FIG. 3). In the operation 905a, for example, a method such as spin coating may be used, but is not limited thereto. The operation 905a may be referred to as a molding process.

In operation 907a, an operation of grinding the insulating member of the package by a first thickness may be performed. For example, an upper surface 1051 (e.g., the upper surface 511 of FIG. 3) of the insulating member 1050 of the package may be ground by a first thickness h1. The first thickness h1 may be, for example, 300 µm to 320 µm, but is not limited thereto. Thereafter, a lower surface 1022 (e.g., the second surface 22 of the substrate 20 of FIG. 3) of a substrate 1020 may be ground after inverting the package. A thickness of the substrate 1020 after grinding of the lower surface 1022 may be 20 µm to 50 µm, but is not limited thereto. The operation 907a may be referred to as a grinding process.

In operation 909a, an operation of removing a portion of the grounded insulating member to expose the plurality of pads by a second thickness may be performed. For example, a portion of the insulating member 1050 of the package may be removed by a second thickness h2 to expose a plurality of pads 1040. The second thickness h2 may be less than the first thickness h1. The second thickness h2 may be, for example, 30 µm to 60 µm, but is not limited thereto. The operation 909a may be referred to as a through mold via (TMV) process.

In operation 911a, an operation of cutting the package in which the plurality of pads are exposed into a plurality of chips may be performed. For example, the package in which the plurality of pads 1040 are exposed may be cut into a plurality of chips 1060. Accordingly, a fingerprint sensor package (e.g., the fingerprint sensor 1 of FIG. 3) may be manufactured. Each of the plurality of chips 1060 may include each of sensor circuits 1040. The operation 911a may be referred to as a package saw process.

In operation 913a, an operation of connecting a flexible printed circuit board to each of the plurality of chips may be performed. For example, a connecting member 1060 (e.g., the connecting member 60 of FIG. 3) may be connected to the fingerprint sensor package.

The manufacturing method of the fingerprint sensor (e.g., the fingerprint sensor 2 of FIG. 6) according to an embodiment will be described with reference to FIGS. 9B, 10A, and 10B.

In operation 901b, an operation of patterning fingerprint sensor circuits including a plurality of pads on a wafer may be performed. For example, sensor circuits 1030 including the plurality of pads (e.g., the plurality of pads 40 of FIG. 6) may be formed on a wafer 1010. The sensor circuits 1030 may include, for example, the sensor circuitry 30-1 of FIG. 6. The operation 901b may include an operation of forming a first conductive layer (e.g., the first conductive layer 32 of FIG. 6) on the wafer 1010, an operation of coating a primer (e.g., the primer layer 38 of FIG. 6) on the wafer 1010 on which the first conductive layer is formed, an operation of depositing a piezoelectric material (e.g., the piezoelectric layer 36 of FIG. 6) on the wafer 1010 coated with the primer, an operation of polarizing electrons inside the deposited piezoelectric material, and an operation of forming a second conductive layer (e.g., the second conductive layer 34 of FIG. 6) on the wafer 1010 on which the piezoelectric material is deposited. The operation 901b may be referred to as a patterning process.

In operation 903b, an operation of cutting the patterned wafer into a first plurality of chips and disposing the cut first plurality of chips on a wafer carrier to be spaced apart from each other may be performed. For example, after the sensor circuits 1030 cut the patterned wafer 1010 into a first plurality of chips 1032, the first plurality of chips 1032 may be disposed on a wafer carrier 1012 to be spaced apart from each other. Each of the first plurality of chips 1032 may include each of the sensor circuits 1030. The operation 903b may be referred to as a dicing saw and a wafer reconstruction process.

In operation 905b, an operation of forming a package may be performed by sealing the fingerprint sensor circuits of the first plurality of chips with an insulating member. For example, a package may be formed by covering the first plurality of chips 1032 and the sensor circuits 1030 on a wafer carrier 1012 with an insulating member 1050 (e.g., the insulating member 50 of FIG. 6). In the operation 905b, for example, a method such as spin coating may be used, but it is not limited thereto. The operation 905b may be referred to as a molding process.

In operation 907b, an operation of grinding the insulating member of the package by a first thickness may be performed. For example, an upper surface 1051 (e.g., the upper surface 511 of FIG. 6) of the insulating member 1050 of the package may be ground by a first thickness h1. The first thickness h1 may be, for example, 300 µm to 320 µm, but is not limited thereto. Thereafter, a lower surface 1022 (e.g., the second surface 22 of the substrate 20 of FIG. 6) of a substrate 1020 may be ground after inverting the package. A thickness of the substrate 1020 after grinding of the lower surface 1022 may be 20 µm to 50 µm, but is not limited thereto. The operation 907b may be referred to as a grinding process.

In operation 909b, an operation of removing a portion of the grounded insulating member by a second thickness to expose the plurality of pads may be performed. For example, a portion of the insulating member 1050 of the package may be removed by a second thickness h2 to expose a plurality of pads 1040. The second thickness h2 may be less than the first thickness h1. The second thickness h2 may be, for example, 30 µm to 60 µm, but is not limited thereto. The operation 909b may be referred to as a TMV process.

In operation 911b, an operation of cutting the package in which the plurality of pads are exposed into a second plurality of chips may be performed. For example, the package in which the plurality of pads 1040 exposed may be cut into a second plurality of chips 1061. Accordingly, a fingerprint sensor package (e.g., the fingerprint sensor 2 of FIG. 6) may be manufactured. Each of the second plurality of chips 1061 may include each of sensor circuits 1040. A size of each of the second plurality of chips 1061 may be larger than a size of each of the first plurality of chips 1032. The operation 911b may be referred to as a package saw process.

In operation 913b, an operation of connecting a flexible printed circuit board to each of the second plurality of chips may be performed. For example, a connecting member 1060 (e.g., the connecting member 60 of FIG. 6) may be connected to the fingerprint sensor package.

A manufacturing method of a fingerprint sensor package (e.g., the fingerprint sensor 1 of FIG. 3 or the fingerprint sensor 2 of FIG. 6), according to an embodiment, may include patterning (e.g., the operations 901a and 901b of FIGS. 9A and 9B) fingerprint sensor circuits (e.g., the fingerprint sensor circuits 1030 of FIG. 10A) including a plurality of pads (e.g., the plurality of pads 40 of FIGS. 3 or 6) on a wafer (e.g., the wafer 1010 of FIG. 10A). The manufacturing method may include forming (e.g., the operations 905a and 905b of FIGS. 9A and 9B) a package by sealing the fingerprint sensor circuits with an insulating member (e.g., the insulating member 1050 of FIG. 10A). The manufacturing method may include grinding (e.g., the operations 907a and 907b of FIGS. 9A and 9B) the insulating member of the package by a first thickness (e.g., the first thickness h1 of FIG. 10B). The manufacturing method may include removing (e.g., the operations 909a and 909b of FIGS. 9A and 9B) a portion of the grounded insulating member by a second thickness (e.g., the second thickness h2 of FIG. 10B) to expose the plurality of pads. The second thickness may be less than the first thickness.

The manufacturing method according to an embodiment may include cutting (e.g., the operations 911a and 911b of FIGS. 9A and 9B) the package in which the plurality of pads are exposed into a plurality of chips. Each of the plurality of chips may include each of the fingerprint sensor circuits.

The manufacturing method according to an embodiment may include cutting the patterned wafer into a first plurality of chips (e.g., the first plurality of chips 1032 of FIG. 10A), and disposing (the operation 903b of FIGS. 9A and 9B) the cut first plurality of chips on a wafer carrier (e.g., the wafer carrier 1012 of FIG. 10A) to be spaced apart from each other. The manufacturing method may include forming (e.g., the operation 905b of FIGS. 9A and 9B) the package by sealing the fingerprint sensor circuits of the first plurality of chips with the insulating member. The manufacturing method may include cutting (e.g., the operation 911b of FIGS. 9A and 9B) the package in which the plurality of pads are exposed into a second plurality of chips. Each of the first plurality of chips may include each of the fingerprint sensor circuits. Each of the second plurality of chips may include each of the fingerprint sensor circuits. A size of each of the second plurality of chips may be greater than a size of each of the first plurality of chips.

In an embodiment, the wafer may include a first surface on which the fingerprint sensor circuits are formed and a second surface opposite to the first surface, the manufacturing method may include grinding (e.g., the operations 907a and 907b of FIGS. 9A and 9B) the second surface of the wafer. The manufacturing method may include connecting (e.g., the operation 911b of FIGS. 9A and 9B) a flexible printed circuit board (e.g., the connecting member 1060 of FIG. 10B) to each of the second plurality of chips.

In an embodiment, the patterning the fingerprint sensor circuits including the plurality of pads on the wafer may include forming a first conductive layer (e.g., the first conductive layer 32 of FIG. 6) on the wafer, coating a primer (e.g., the primer 38 of FIG. 6) on the wafer on which the first conductive layer is formed, depositing a piezoelectric material (e.g., the piezoelectric layer 36 of FIG. 6) on the wafer coated with the primer, and forming a second conductive layer (e.g., the second conductive layer 34 of FIG. 6) on the wafer on which the piezoelectric material is deposited.

FIG. 11 is a block diagram illustrating an electronic device 1101 in a network environment 1100 according to various embodiments. Referring to FIG. 11, the electronic device 1101 in the network environment 1100 may communicate with an electronic device 1102 via a first network 1198 (e.g., a short-range wireless communication network), or at least one of an electronic device 1104 or a server 1108 via a second network 1199 (e.g., a long-range wireless communication network). According to an embodiment, the electronic device 1101 may communicate with the electronic device 1104 via the server 1108. According to an embodiment, the electronic device 1101 may include a processor 1120, memory 1130, an input module 1150, a sound output module 1155, a display module 1160, an audio module 1170, a sensor module 1176, an interface 1177, a connecting terminal 1178, a haptic module 1179, a camera module 1180, a power management module 1188, a battery 1189, a communication module 1190, a subscriber identification module(SIM) 1196, or an antenna module 1197. In some embodiments, at least one of the components (e.g., the connecting terminal 1178) may be omitted from the electronic device 1101, or one or more other components may be added in the electronic device 1101. In some embodiments, some of the components (e.g., the sensor module 1176, the camera module 1180, or the antenna module 1197) may be implemented as a single component (e.g., the display module 1160).

The processor 1120 may execute, for example, software (e.g., a program 1140) to control at least one other component (e.g., a hardware or software component) of the electronic device 1101 coupled with the processor 1120, and may perform various data processing or computation. According to an embodiment, as at least part of the data processing or computation, the processor 1120 may store a command or data received from another component (e.g., the sensor module 1176 or the communication module 1190) in volatile memory 1132, process the command or the data stored in the volatile memory 1132, and store resulting data in non-volatile memory 1134. According to an embodiment, the processor 1120 may include a main processor 1121 (e.g., a central processing unit (CPU) or an application processor (AP)), or an auxiliary processor 1123 (e.g., a graphics processing unit (GPU), a neural processing unit (NPU), an image signal processor (ISP), a sensor hub processor, or a communication processor (CP)) that is operable independently from, or in conjunction with, the main processor 1121. For example, when the electronic device 1101 includes the main processor 1121 and the auxiliary processor 1123, the auxiliary processor 1123 may be adapted to consume less power than the main processor 1121, or to be specific to a specified function. The auxiliary processor 1123 may be implemented as separate from, or as part of the main processor 1121.

The auxiliary processor 1123 may control at least some of functions or states related to at least one component (e.g., the display module 1160, the sensor module 1176, or the communication module 1190) among the components of the electronic device 1101, instead of the main processor 1121 while the main processor 1121 is in an inactive (e.g., sleep) state, or together with the main processor 1121 while the main processor 1121 is in an active state (e.g., executing an application). According to an embodiment, the auxiliary processor 1123 (e.g., an image signal processor or a communication processor) may be implemented as part of another component (e.g., the camera module 1180 or the communication module 1190) functionally related to the auxiliary processor 1123. According to an embodiment, the auxiliary processor 1123 (e.g., the neural processing unit) may include a hardware structure specified for artificial intelligence model processing. An artificial intelligence model may be generated by machine learning. Such learning may be performed, e.g., by the electronic device 1101 where the artificial intelligence is performed or via a separate server (e.g., the server 1108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1130 may store various data used by at least one component (e.g., the processor 1120 or the sensor module 1176) of the electronic device 1101. The various data may include, for example, software (e.g., the program 1140) and input data or output data for a command related thereto. The memory 1130 may include the volatile memory 1132 or the non-volatile memory 1134.

The program 1140 may be stored in the memory 1130 as software, and may include, for example, an operating system (OS) 1142, middleware 1144, or an application 1146.

The input module 1150 may receive a command or data to be used by another component (e.g., the processor 1120) of the electronic device 1101, from the outside (e.g., a user) of the electronic device 1101. The input module 1150 may include, for example, a microphone, a mouse, a keyboard, a key (e.g., a button), or a digital pen (e.g., a stylus pen).

The sound output module 1155 may output sound signals to the outside of the electronic device 1101. The sound output module 1155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1160 may visually provide information to the outside (e.g., a user) of the electronic device 1101. The display module 1160 may include, for example, a display, a hologram device, or a projector and control circuitry to control a corresponding one of the display, hologram device, and projector. According to an embodiment, the display module 1160 may include a touch sensor adapted to detect a touch, or a pressure sensor adapted to measure the intensity of force incurred by the touch.

The audio module 1170 may convert a sound into an electrical signal and vice versa. According to an embodiment, the audio module 1170 may obtain the sound via the input module 1150, or output the sound via the sound output module 1155 or a headphone of an external electronic device (e.g., an electronic device 1102) directly (e.g., wiredly) or wirelessly coupled with the electronic device 1101.

The sensor module 1176 may detect an operational state (e.g., power or temperature) of the electronic device 1101 or an environmental state (e.g., a state of a user) external to the electronic device 1101, and then generate an electrical signal or data value corresponding to the detected state. According to an embodiment, the sensor module 1176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1177 may support one or more specified protocols to be used for the electronic device 1101 to be coupled with the external electronic device (e.g., the electronic device 1102) directly (e.g., wiredly) or wirelessly. According to an embodiment, the interface 1177 may include, for example, a high definition multimedia interface (HDMI), a universal serial bus (USB) interface, a secure digital (SD) card interface, or an audio interface.

A connecting terminal 1178 may include a connector via which the electronic device 1101 may be physically connected with the external electronic device (e.g., the electronic device 1102). According to an embodiment, the connecting terminal 1178 may include, for example, an HDMI connector, a USB connector, an SD card connector, or an audio connector (e.g., a headphone connector).

The haptic module 1179 may convert an electrical signal into a mechanical stimulus (e.g., a vibration or a movement) or electrical stimulus which may be recognized by a user via his tactile sensation or kinesthetic sensation. According to an embodiment, the haptic module 1179 may include, for example, a motor, a piezoelectric element, or an electric stimulator.

The camera module 1180 may capture a still image or moving images. According to an embodiment, the camera module 1180 may include one or more lenses, image sensors, image signal processors, or flashes.

The power management module 1188 may manage power supplied to the electronic device 1101. According to an embodiment, the power management module 1188 may be implemented as at least part of, for example, a power management integrated circuit (PMIC).

The battery 1189 may supply power to at least one component of the electronic device 1101. According to an embodiment, the battery 1189 may include, for example, a primary cell which is not rechargeable, a secondary cell which is rechargeable, or a fuel cell.

The communication module 1190 may support establishing a direct (e.g., wired) communication channel or a wireless communication channel between the electronic device 1101 and the external electronic device (e.g., the electronic device 1102, the electronic device 1104, or the server 1108) and performing communication via the established communication channel. The communication module 1190 may include one or more communication processors that are operable independently from the processor 1120 (e.g., the application processor (AP)) and supports a direct (e.g., wired) communication or a wireless communication. According to an embodiment, the communication module 1190 may include a wireless communication module 1192 (e.g., a cellular communication module, a short-range wireless communication module, or a global navigation satellite system (GNSS) communication module) or a wired communication module 1194 (e.g., a local area network (LAN) communication module or a power line communication (PLC) module). A corresponding one of these communication modules may communicate with the external electronic device via the first network 1198 (e.g., a short-range communication network, such as Bluetooth^{™}, wireless-fidelity (Wi-Fi) direct, or infrared data association (IrDA)) or the second network 1199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1192 may identify and authenticate the electronic device 1101 in a communication network, such as the first network 1198 or the second network 1199, using subscriber information (e.g., international mobile subscriber identity (IMSI)) stored in the subscriber identification module 1196.

The wireless communication module 1192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1192 may support a high-frequency band (e.g., the mmWave band) to achieve, e.g., a high data transmission rate. The wireless communication module 1192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1192 may support various requirements specified in the electronic device 1101, an external electronic device (e.g., the electronic device 1104), or a network system (e.g., the second network 1199). According to an embodiment, the wireless communication module 1192 may support a peak data rate (e.g., 20Gbps or more) for implementing eMBB, loss coverage (e.g., 1164dB or less) for implementing mMTC, or U-plane latency (e.g., 0.5ms or less for each of downlink (DL) and uplink (UL), or a round trip of 11ms or less) for implementing URLLC.

The antenna module 1197 may transmit or receive a signal or power to or from the outside (e.g., the external electronic device) of the electronic device 1101. According to an embodiment, the antenna module 1197 may include an antenna including a radiating element composed of a conductive material or a conductive pattern formed in or on a substrate (e.g., a printed circuit board (PCB)). According to an embodiment, the antenna module 1197 may include a plurality of antennas (e.g., array antennas). In such a case, at least one antenna appropriate for a communication scheme used in the communication network, such as the first network 1198 or the second network 1199, may be selected, for example, by the communication module 1190 (e.g., the wireless communication module 1192) from the plurality of antennas. The signal or the power may then be transmitted or received between the communication module 1190 and the external electronic device via the selected at least one antenna. According to an embodiment, another component (e.g., a radio frequency integrated circuit (RFIC)) other than the radiating element may be additionally formed as part of the antenna module 1197.

According to various embodiments, the antenna module 1197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1101 and the external electronic device 1104 via the server 1108 coupled with the second network 1199. Each of the electronic devices 1102 or 1104 may be a device of a same type as, or a different type, from the electronic device 1101. According to an embodiment, all or some of operations to be executed at the electronic device 1101 may be executed at one or more of the external electronic devices 1102, 1104, or 1108. For example, if the electronic device 1101 should perform a function or a service automatically, or in response to a request from a user or another device, the electronic device 1101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1101. The electronic device 1101 may provide the outcome, with or without further processing of the outcome, as at least part of a reply to the request. To that end, a cloud computing, distributed computing, mobile edge computing (MEC), or client-server computing technology may be used, for example. The electronic device 1101 may provide ultra low-latency services using, e.g., distributed computing or mobile edge computing. In another embodiment, the external electronic device 1104 may include an internet-of-things (IoT) device. The server 1108 may be an intelligent server using machine learning and/or a neural network. According to an embodiment, the external electronic device 1104 or the server 1108 may be included in the second network 1199. The electronic device 1101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 1140) including one or more instructions that are stored in a storage medium (e.g., internal memory 1136 or external memory 1138) that is readable by a machine (e.g., the electronic device 1101). For example, a processor (e.g., the processor 1120) of the machine (e.g., the electronic device 1101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a substrate including:
a first surface including a first region and a second region spaced apart from the first region;
a second surface opposite to the first surface; and
a third surface extending from an edge of the first surface to an edge of the second surface;
fingerprint sensor circuitry formed on the first region;
an insulating member including a first portion disposed on the first region to cover the fingerprint sensor circuitry and a second portion extending from the first portion to surround the third surface;
a plurality of pads formed on the second region and respectively connected to the fingerprint sensor circuitry via electrical paths formed in the substrate; and
a connecting member connected to the plurality of pads and including a portion located on the second region.

2. The electronic device of claim 1, wherein the insulating member is not formed on the second region.

3. The electronic device of any one of the preceding claims, wherein:
the first surface of the substrate faces a first direction;
the first portion of the insulating member includes an upper surface spaced apart from the first surface of the substrate in the first direction; and
the portion of the connecting member is located between the second region and an imaginary plane including the upper surface.

4. The electronic device of claim 3, wherein the portion of the connecting member is a portion overlapping the substrate based on the first direction.

5. The electronic device of any one of the preceding claims, wherein:
the second region forms a part of an edge of the first surface of the substrate; and
the second portion of the insulating member includes a sub-portion forming a surface extending from the part of the edge of the first surface.

6. The electronic device of claim 5, wherein the surface formed by the sub-portion extends parallel to the first surface.

7. The electronic device of claim 5 or claim 6, wherein:
the first surface of the substrate faces a first direction;
the second region includes an edge extending from one end to another end of the part of the edge of the first surface; and
the first portion of the insulating member includes:
an upper surface spaced apart from the first surface of the substrate in the first direction; and
a side surface extending from the edge of the second region to an edge of the upper surface.

8. The electronic device of claim 7, wherein the side surface is inclined with respect to the first surface.

9. The electronic device of claim 8, wherein the side surface of the insulating member is formed such that a distance from the plurality of pads increases as the side surface approaches the upper surface, the distance based on a direction parallel to the first surface.

10. The electronic device of any one of the preceding claims, comprising a display, and wherein the second surface of the substrate is attached to the display.

11. The electronic device of any one of claims 1 to 9, comprising a dome switch disposed below the second surface of the substrate.

12. The electronic device of any one of claims 1 to 9, and claim 11, wherein:
the insulating member includes an upper surface exposed to the outside of the electronic device; and
the fingerprint sensor circuitry is configured to detect capacitance with a part of a body of a user adjacent to the upper surface.

13. The electronic device of any one of claims 1 to 11, wherein the fingerprint sensor circuitry is configured to:
transmit ultrasonic waves to a part of a body of a user through the second surface of the substrate; and
receive at least a portion of the ultrasonic waves reflected from the part of the body of the user.

14. The electronic device of claim 13, wherein the fingerprint sensor circuitry includes:
a first conductive layer;
a second conductive layer; and
a piezoelectric layer connected to the first conductive layer and the second conductive layer, and wherein:
the first conductive layer and the piezoelectric layer are configured to generate the ultrasonic waves; and
the second conductive layer and the piezoelectric layer are configured to receive the at least a portion of the ultrasound waves.

15. A manufacturing method of a fingerprint sensor package, comprising:
patterning fingerprint sensor circuits comprising a plurality of pads on a wafer;
forming a package by sealing the fingerprint sensor circuits with an insulating member;
grinding the insulating member of the package by a first thickness; and
removing a portion of the grounded insulating member by a second thickness to expose the plurality of pads, the second thickness less than the first thickness.
